# EUROPÄISCHE PATENTANMELDUNG

(11) **EP 4 831 650 A1**
(43) Veröffentlichungstag der Anmeldung: **28.10.2026**
(21) Anmeldenummer: 26170527.1
(22) Anmeldetag: 02.04.2026
(51) Int. Cl.: G01R 15/12, G01R 15/14, G01R 15/18

(54) **ELEKTRONISCHES MESSGERÄT MIT DUAL-USE BATTERIEFACH**

(30) Priorität: 25.04.2025 DE 102025116057
(71) Anmelder: Robert Bosch GmbH, 70442 Stuttgart (DE)
(72) Erfinder: Chan, Chi Fung, 73760 Ostfildern (DE); Ying, Jianbang, Hangzhou, Zhejiang, 311400 (CN); Zhang, Xinhui, Hangzhou, 311400 (CN); Kohlert, Thomas, 29780 Nerja (ES)

(57) **Zusammenfassung**

Die Erfindung bezieht sich auf ein elektronisches Messgerät (10) zur Messung elektrischer Größen, insbesondere von Strömen, Spannungen und/oder ohmschen Widerständen. Im Gehäuse (12) des elektronischen Messgerätes (10) ist ein Batteriefach (16) zur Aufnahme einer Energiequelle (17) ausgebildet, welches mittels eines Batteriefachdeckels (22) verschließbar ist. Der Batteriefachdeckel (22) ist eingerichtet, sowohl das Batteriefach (16) mit in diesem eingelegten Batterien (24) als auch mit am Batteriefachdeckel (22) angeordnetem, wiederaufladbarem Akkumulator (34) oder Akkupack zu verschließen.

## Beschreibung

### Technisches Gebiet

Die Erfindung bezieht sich auf ein elektronisches Messgerät zur Messung elektrischer Größen, insbesondere von Strömen, Spannungen und/oder ohmschen Widerständen, in dessen Gehäuse ein Batteriefach zur Aufnahme einer Stromquelle ausgebildet ist, welches mittels eines Batteriefachdeckels verschließbar ist.

### Stand der Technik

CN 220086290 U offenbart eine Batterieabdeckung sowie ein Multimeter mit einer derartigen Batterieabdeckung. Die obere Batterieabdeckung wird während des Aufladens entfernt. Sie dient ansonsten der Vermeidung elektrischer Schläge, Ölflecken, Staub- und Wasserflecken oder anderer derartiger Kontaminationen.

DE 10 2008 036 823 A1 offenbart eine Gehäusestruktur mit einem Gehäuse sowie ein entsprechendes Multimeter. Das Gehäuse besitzt eine Schale aus steifem Polymermaterial, welches wenigstens eine ein weicheres Polymermaterial enthaltende Nut definiert. Zusätzlich umfasst die Gehäusestruktur wenigstens ein steifes Plattenelement, das an dem Gehäuse anliegt. Hierbei wird unter anderem ein Ansatz für eine Dichtungsanordnung zwischen dem Batteriefach und dem Batteriefachdeckel offenbart, um das Eindringen von Feuchtigkeit und anderer Verunreinigungen zu verhindern.

DE 10 2009 001 735 A1 offenbart ein elektrisches Gerät, insbesondere einen Laserentfernungsmesser und einen Batteriefachdeckel hierfür. Es wird vorgeschlagen, dass ein Abdeckelement des Batteriefachdeckels an seiner Innenseite einen Halter für die Aufnahme von wenigstens einer Batterie aufweist, die Batterien demnach im Batteriefachdeckel platzierbar sind. Der Batteriefachdeckel ermöglicht eine einfache Handhabung und bildet gleichzeitig einen sicheren Verschluss des Batteriefachs des elektrischen Gerätes.

### Offenbarung der Erfindung

Erfindungsgemäß wird ein elektronisches Messgerät vorgeschlagen, zur Messung elektrischer Größen, insbesondere von Strömen, Spannungen und/oder ohmschen Widerständen, in dessen Gehäuse ein Batteriefach zur Aufnahme einer Energiequelle ausgebildet ist, welches mittels eines Batteriefachdeckels verschließbar ist. Der Batteriefachdeckel ist eingerichtet, sowohl das Batteriefach mit in dieses eingelegten Batterien als auch mit am Batteriefachdeckel bestücktem, wiederaufladbarem Akkumulator zu verschließen. Damit kann ein elektronisches Messgerät im Dual-Use-Betriebsmodus, d. h. im Betrieb mit herkömmlichen Alkaline-Batterien als auch mit einem wiederaufladbaren Akkumulator beziehungsweise einem Akkupack, der mehrere wiederaufladbare Akkumulatoren umfasst, betrieben werden, wobei zum Verschließen des Batteriefachs des elektronischen Messgerätes ein und derselbe Batteriefachdeckel Verwendung findet.

In vorteilhafter Weiterbildung des elektronischen Messgerätes ist vorgesehen, dass an einer Innenseite des Batteriefachdeckels den wiederaufladbaren Akkumulator beziehungsweise den Akkupack fixierende Montagestrukturen angeordnet sind.

In einer vorteilhaften Ausführungsvariante des erfindungsgemäß vorgeschlagenen elektronischen Messgerätes sind die Montagestrukturen derart ausgeführt, dass der wiederaufladbare Akkumulator oder ein wiederaufladbares Akkupack, mehrere einzelne Akkumulatoren umfassend, in Umfangsrichtung von den Montagestrukturen umgriffen ist oder in Umfangsrichtung an diesen anliegt oder diese aufnimmt.

Beim elektronischen Messgerät ist in vorteilhafter Weise vorgesehen, dass der wiederaufladbare Akkumulator oder der Akkupack an der Innenseite des Batteriefachdeckels von einem hakenförmigen Vorsprung übergriffen und fixiert ist. Der hakenförmige Vorsprung kann mittels des Kunststoffspritzgießverfahrens, bei der Fertigung des Batteriefachdeckels einfach im Spritzwerkzeug ausgebildet werden.

Des Weiteren ist beim erfindungsgemäß vorgeschlagenen elektronischen Messgerät vorgesehen, dass der wiederaufladbare Akkumulator oder der Akkupack an einer dem hakenförmigen Vorsprung an der Innenseite des Batteriefachdeckels gegenüberliegenden Seite mittels einer Ausrichtrippe und einer Freigabeeinrichtung fixiert ist. Die Freigabeeinrichtung und die Ausrichtrippe sind an der Innenseite des Batteriefachdeckels so positioniert, dass ein korrektes Einlegen des Akkumulators oder des Akkupacks und dessen Fixieren aufgrund der Ausrichtrippe möglich ist. Zum korrekten Fixieren wird der wiederaufladbare Akkumulator oder der Akkupack in seine Position eingelegt und mittels der Freigabeeinrichtung manuell an der Innenseite des Batteriefachdeckels befestigt.

In vorteilhafter Weiterbildung des erfindungsgemäß vorgeschlagenen elektronischen Messgerätes ist die Freigabeeinrichtung als Drehvorsprung oder als Kippschalter ausgeführt.

Beim erfindungsgemäß vorgeschlagenen elektronischen Messgerät ist in vorteilhafter Weise vorgesehen, dass der Drehvorsprung oder der Kippschalter jeweils mittels eines Federelements beaufschlagt sind, welches den Drehvorsprung beziehungsweise den Kippschalter in Schließrichtung drängt. Nach dem Einlegen des wiederaufladbaren Akkumulators oder des Akkupacks in den hakenförmigen Vorsprung einer Innenseite des Batteriefachdeckels liegt der wiederaufladbare Akkumulator oder der Akkupack an der Ausrichtrippe an und wird mittels des in Schließrichtung federbeaufschlagten Drehschalters beziehungsweise mittels des in Schließrichtung federbeaufschlagbaren Kippschalters mit einer Einrastbewegung an der Innenseite des Batteriefachdeckels temporär fixiert.

In vorteilhafter Weiterbildung des erfindungsgemäß vorgeschlagenen elektronischen Messgerätes ist eine Bodenkontur des Batteriefachs komplementär zur Außenkontur eines Gehäuses des wiederaufladbaren Akkumulators oder Akkupacks ausgebildet. Durch die Verwirklichung eines Dual-Use-Betriebsmodus, d. h. sowohl mit herkömmlichen, nicht-aufladbaren Alkaline-Batterien als auch mittels eines wiederaufladbaren Akkumulators oder Akkupacks betreibbar, entfällt das Erfordernis eines Adapters, da die Bodenkontur des Batteriefachs einerseits und die Außenkontur des wiederaufladbaren Akkumulators oder Akkupacks andererseits aufeinander abgestimmt sind.

Das erfindungsgemäß vorgeschlagene elektronische Messgerät ist als Multimeter, als Zangenamperemeter, als Gabelamperemeter oder als Spannungsmessgerät zur Messung elektrischer Größen ausgeführt, insbesondere von Strömen, Spannungen, elektrischen Widerständen, Kapazitäten, Temperaturen oder Impedanzen sowohl in Gleichstrom- als auch in Wechselstromanwendungen.

### Vorteile der Erfindung

Das erfindungsgemäß vorgeschlagene elektronische Messgerät kann sowohl mit herkömmlichen, nicht-aufladbaren Batterien als auch mittels eines wiederaufladbaren Akkumulators oder Akkupacks betrieben werden. Insbesondere bei Einsatz des wiederaufladbaren Akkumulators oder Akkupacks kann dieser, ohne dass ein Adapter erforderlich wäre, an Montagestrukturen an der Innenseite des das Batteriefach überdeckenden Batteriefachdeckels fixiert werden. Der Batteriefachdeckel ist so ausgebildet, dass dieser einerseits in das Batteriefach eingelegte, herkömmliche Batterien ausrichtet und innerhalb des Batteriefachs fixiert, und ist andererseits so beschaffen, dass mittels eines einfachen Einlegeprozesses der wiederaufladbare Akkumulator oder Akkupack an der Innenseite des Batteriefachdeckels fixiert werden kann.

Dazu sind an der Innenseite des Batteriefachdeckels Montagestrukturen ausgebildet, die einen hakenförmigen Vorsprung umfassen sowie eine Freigabeeinrichtung in Gestalt eines federbeaufschlagten Drehschalters oder eines federbeaufschlagten Kippschalters.

Nach dem Einlegen des wiederaufladbaren Akkumulators oder Akkupacks, dessen Gehäuse eine Umrandung aufweist, wird diese Umrandung vom hakenförmigen Vorsprung übergriffen, das Gehäuse an der Ausrichtrippe im Batteriefach ausgerichtet und dieses in das Batteriefach eingelegt. Nach erfolgtem Ausrichten des wiederaufladbaren Akkumulators oder Akkupacks an der Ausrichtrippe rastet der mittels eines Federelements beaufschlagbare Drehvorsprung oder mittels eines Federelements beaufschlagte Kippschalter ein und übergreift aufgrund seiner Federbeaufschlagung in Schließrichtung die Umrandung des Gehäuses des wiederaufladbaren Akkumulators oder Akkupacks. Damit ist dieser mit wenigen Handgriffen an der Innenseite des Batteriefachdeckels fixiert. Dieser mit dem wiederaufladbaren Akkumulator oder dem Akkupack bestückte Batteriefachdeckel lässt sich nun einfach auf das Batteriefach auflegen und verschließt dieses.

Somit kann mit ein und demselben Batteriefachdeckel ein Dual-Use-Betrieb des erfindungsgemäß vorgeschlagenen elektronischen Messgerätes mit einem Minimum an Aufwand für den Benutzer und insbesondere unter Verzicht auf eine anderenfalls erforderliche Adaptereinrichtung verwirklicht werden.

Des Weiteren ist durch die erfindungsgemäß vorgeschlagene Lösung sichergestellt, dass bei Lösen des Batteriefachdeckels der an diesem fixierte wiederaufladbare Akkumulator bei Entnahme des Batteriefachdeckels aus dem Gehäuse entfernt wird. Damit wird verhindert, dass der wiederaufladbare Akkumulator oder Akkupack im Batteriefach verbleibt. Durch die sichere Entnahme des wiederaufladbaren Akkumulators oder Akkupacks aus dem Batteriefach bei Öffnen des Batteriefachdeckels hat der Bediener des elektronischen Messgerätes keine Möglichkeit, den wiederaufladbaren Akkumulator oder den Akkupack innerhalb des Batteriefachs aufzuladen. Dadurch kann die Bediensicherheit des erfindungsgemäß vorgeschlagenen elektronischen Messgerätes erheblich verbessert werden, da der Bediener davon abgehalten wird, den wiederaufladbaren Akkumulator oder den Akkupack im in das Batteriefach eingelegten Zustand aufzuladen.

Gemäß der vorgeschlagenen Lösung verschließt der Batteriefachdeckel stets das Batteriefach, sowohl wenn Batterien in dieses eingesetzt sind als auch wenn ein wiederaufladbarer Akkumulator oder ein Akkupack eingesetzt ist. Die an der dem Batteriefach zuweisenden Seite, d. h. der Innenseite des Batteriefachdeckels angeordneten Montagestrukturen können sowohl den wiederaufladbaren Akkumulator als auch ein wiederaufladbares Akkupack aufnehmen, aber auch handelsübliche Batterien.

### Kurze Beschreibung der Zeichnungen

Ausführungsformen der Erfindung werden anhand der Zeichnungen und der nachfolgenden Beschreibung näher erläutert.

Es zeigen:
- Figur 1: eine perspektivische Ansicht eines elektronischen Messgerätes,
- Figuren 1.1 - 1.5: die Bestückung des Batteriefachs mit herkömmlichen Batterien und dessen Verschluss mittels des Batteriefachdeckels,
- Figuren 2.1 - 2.4: die Bestückung des Batteriefachs mit einem Batteriefachdeckel, an dessen Innenseite ein wiederaufladbarer Akkumulator oder ein Akkupack aufgenommen ist.
- Figuren 3 und 4: die Montagestrukturen an der Innenseite des Batteriefachdeckels,
- Figur 5: eine perspektivische Draufsicht auf einen vereinfacht ausgebildeten Batteriefachdeckel mit in diesem vorgesehenen Montagestrukturen zur Aufnahme des wiederaufladbaren Akkumulators oder Akkupacks,
- Figur 5.1: eine Draufsicht auf einen Kippschalter,
- Figur 5.2: eine Draufsicht auf einen Drehvorsprung und
- Figur 6: die perspektivische Draufsicht auf einen an der Innenseite des Batteriefachdeckels angeordneten wiederaufladbaren Akkumulator oder Akkupack.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

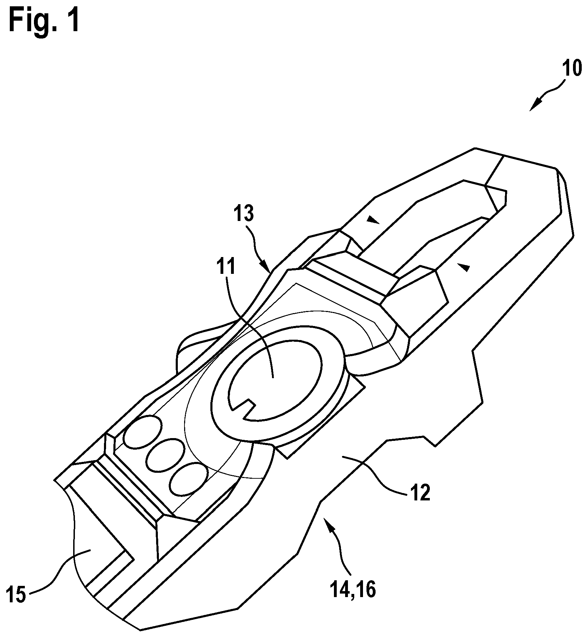

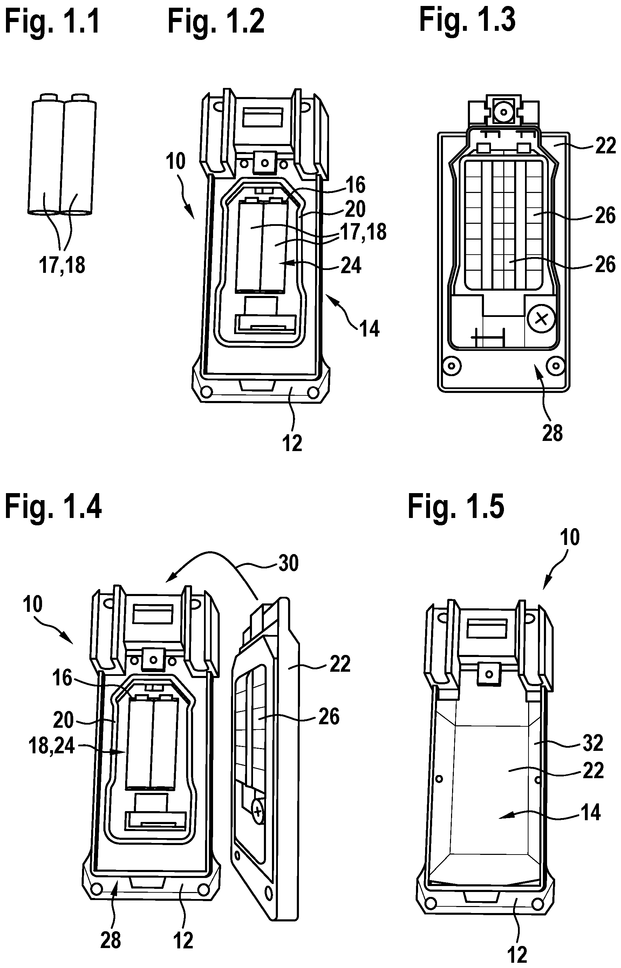

Der Darstellung gemäß Figur 1 ist eine perspektivische Ansicht eines elektronischen Messgerätes 10 zu entnehmen. Ein elektronisches Messgerät 10 umfasst ein Gehäuse 12, in welches ein verdrehbarer Wahlschalter 11 eingelassen ist. Mittels des beispielsweise mit einer Rändelung an seinem Umfang versehenen verdrehbaren Wahlschalters 11 können verschiedene Betriebsmodi am elektronischen Messgerät 10 eingestellt werden. Dadurch kann dieses derart eingestellt werden, dass entweder Spannungen, Ströme, ohmsche Widerstände oder andere elektrische Größen gemessen werden können. Auf einer Vorderseite 13 des Gehäuses 12 des elektronischen Messgerätes 10 befindet sich ein Display 15, während auf einer Rückseite 14 des Gehäuses 12 des elektronischen Messgerätes 10 ein Batteriefach 16 untergebracht ist. Im Batteriefach 16 können sowohl handelsübliche Alkaline-Batterien 18 der Größen AA, AAA oder 9 V-Batterien oder dergleichen eingesetzt werden als auch wiederaufladbare Lithium-Ionen-Akkumulatoren oder ein Akkupack 34, welcher mehrere wiederaufladbare Akkumulatoren umfasst. Das Batteriefach 16 wird in der nachfolgenden Figurenbeschreibung im Einzelnen näher beschrieben.

Der Figurensequenz der Figuren 1.1 bis 1.5 ist eine Bestückung eines Batteriefachs eines elektronischen Messgerätes 10 mit herkömmlichen Batterien zu entnehmen.

Figuren 1.1 und 1.2 zeigen, dass ein Batteriefach 16 an einer Rückseite 14 eines Gehäuses 12 eines elektronischen Messgerätes 10 mit einer Energiequelle 17 in Gestalt von herkömmlichen Batterien 18, beispielsweise Alkaline-Batterien, bestückt ist.

Besagte Batterien 18 sind in Figur 1.2 in das Batteriefach 16 als eingelegte Batterien 24 dargestellt. Das Batteriefach 16 ist von einer Fassung 20 umgeben, die komplementär zu einer Fassung ausgebildet ist, die an einer Innenseite 28 des Batteriefachdeckels 22 umlaufend oder unterbrochen ausgebildet ist. Die Innenseite 28 des Batteriefachdeckels 22 bezeichnet im vorliegenden Zusammenhang die Seite des Batteriefachdeckels 22, an welcher Batterien 18 beziehungsweise ein wiederaufladbarer Akkumulator 34 oder ein Akkupack mit mehreren wiederaufladbaren Akkumulatoren befestigt, beispielsweise eingehängt werden kann, so dass der Umfang der Batterien 18 beziehungsweise des wiederaufladbaren Akkumulators 34 oder des Akkupacks von der Innenseite 28 des Batteriefachdeckels 22, insbesondere von dort angeordneten Montagestrukturen 26 zumindest teilweise umgriffen oder umschlossen wird. Die zueinander komplementären Fassungen 20 am Batteriefach 16 einerseits und an der Innenseite 28 des Batteriefachdeckels 22 andererseits verhindern eine unsachgemäße Montage des Batteriefachdeckels 22 auf dem Batteriefach 16 an der Rückseite 14 des Gehäuses 12.

Aus der Darstellung gemäß Figur 1.3 geht hervor, dass der Batteriefachdeckel 22 eine Innenseite 28 aufweist, welche Montagestrukturen 26 umfasst. Die Montagestrukturen 26 an der Innenseite 28 des Batteriefachdeckels 22 dienen dem ordnungsgemäßen Positionieren und Ausrichten eines wiederaufladbaren Akkumulators 34 oder eines Akkupacks (beziehungsweise von dessen Gehäuse 46) oder von Batterien 18 an der Innenseite 28 des Batteriefachdeckels 22. Die Montagestrukturen 26 können einteilig oder mehrteilig ausgebildet sein. So können beispielsweise die Montagestrukturen 26 zweistückig mit dem Batteriefachdeckel 22 ausgebildet sein. Der Batteriefachdeckel 22 seinerseits kann alternativ auch die Montagestrukturen 26 ausbilden oder dieser kann einstückig ausgebildet sein, wobei die Montagestrukturen 26 ein separates Bauteil darstellen, welches an die Innenseite 28 des Batteriefachdeckels 22 eingeklipst werden kann.

Das erfindungsgemäß vorgeschlagene elektronische Messgerät 10, bei dem es sich um ein Multimeter, ein Zangenamperemeter, ein Gabelamperemeter oder auch um einen Spannungsmesser handeln kann, kann demnach sowohl mit herkömmlichen Alkaline-Batterien 18, als auch mittels eines wiederaufladbaren Akkumulators oder Akkupacks 34, beispielsweise eines Lithium-Ionen-Akkumulators, betrieben werden, ohne dass ein Adapter zur Fixierung des wiederaufladbaren Akkumulators 34 oder des Akkupacks erforderlich wäre.

Aus der Darstellung gemäß Figur 1.3 geht hervor, dass der Batteriefachdeckel 22 mit seinen an dessen Innenseite 28 vorgesehenen Montagestrukturen 26 gemäß Figur 1.4 im Rahmen eines Montageschrittes 30 auf das Batteriefach 16 aufgelegt und an diesem arretiert wird. Der Batteriefachdeckel 22 mit den an seiner Innenseite 28 vorgesehenen Montagestrukturen 26 fixiert demnach die in das Batteriefach 16 gemäß der Darstellung in Figur 1.4 eingelegten Batterien 24, bei welchen es sich um herkömmliche Alkaline-Batterien 18 handelt. Die Fixierung des Batteriefachdeckels 22 erfolgt durch die Fassung 20, die mit Unterbrechungen oder ununterbrochen um das Batteriefach 16 an der Rückseite 14 des Gehäuses 12 herum verläuft und eine komplementär zur Fassung 20 ausgebildete Fassung an der Innenseite 28 des Batteriefachdeckels 22.

Nach dem Einschnappen des Batteriefachdeckels 22 mit in das Batteriefach 16 eingelegten Batterien 24 ergibt sich gemäß der Darstellung in Figur 1.5 eine glatte Rückseite 14 des Gehäuses 12 des elektronischen Messgerätes 10 aufgrund des auf der Oberseite des Batteriefachs 16 verrasteten Batteriefachdeckels 22. Dieser dichtet den Innenraum des Batteriefachs 16 gegen Feuchtigkeit und weitere Umwelteinflüsse ab.

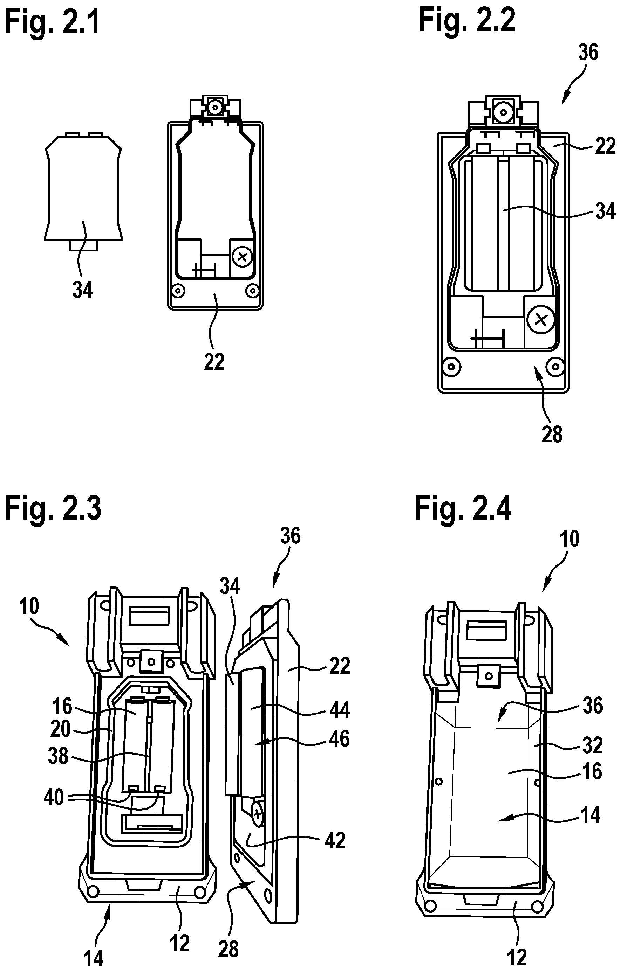

Der Figurensequenz der Figuren 2.1 bis 2.4 ist zu entnehmen, dass ein wiederaufladbarer Akkumulator 34 oder ein Akkupack an der Innenseite 28 des Batteriefachdeckels 22 gemäß der Darstellung in den Figuren 2.1 und 2.2 temporär fixiert wird. Wie aus der Draufsicht gemäß Figur 2.2 entnommen werden kann, ist der wiederaufladbare Akkumulator 34 oder der Akkupack beziehungsweise dessen Gehäuse 46 so beschaffen, dass eine Außenkontur 44 des wiederaufladbaren Akkumulators 34 oder Akkupacks einer Bodenkontur 42 des Batteriefachs 16 im Gehäuse 12 des elektronischen Messgerätes 10 entspricht.

Bei der in Figur 2.3 dargestellten Montage des wiederaufladbaren Akkumulators 34 oder Akkupacks an den Montagestrukturen 26 an der Innenseite 28 des Batteriefachdeckels 22 ist das im Gehäuse 12 ausgebildete Batteriefach 16 selbstverständlich leer. Wie Figur 2.3 zeigt, wird der mit dem wiederaufladbaren Akkumulator 34 oder Akkupack bestückte Batteriefachdeckel 36 auf die Oberseite des Batteriefachs 16 des Gehäuses 12 montiert, dabei liegt der wiederaufladbare Akkumulator 34 oder der Akkupack seiner Formgebung entsprechend im Batteriefach 16, so dass sich gemäß Figur 2.4 im verschlossenen Zustand des elektronischen Messgerätes 10 beziehungsweise im verschlossenen Zustand des Batteriefachs 16 eine glatte Rückseite 14 des Gehäuses 12 des elektronischen Messgerätes 10 ergibt.

Der Darstellung gemäß Figur 2.3 ist zu entnehmen, dass die Formgebung sowohl einer Bodenkontur 42 im Batteriefach 16 des Gehäuses 12 als auch die Außenkontur 44 des Gehäuses 46 des wiederaufladbaren Akkumulators 34 oder Akkupacks aufeinander abgestimmt sind, so dass sich ein sehr leichtes Fügen des mit dem wiederaufladbaren Akkumulator 34 oder Akkupack bestückten Batteriefachdeckels 36 mit dem Batteriefach 16 im Gehäuse 12 des elektronischen Messgerätes 10 ergibt.

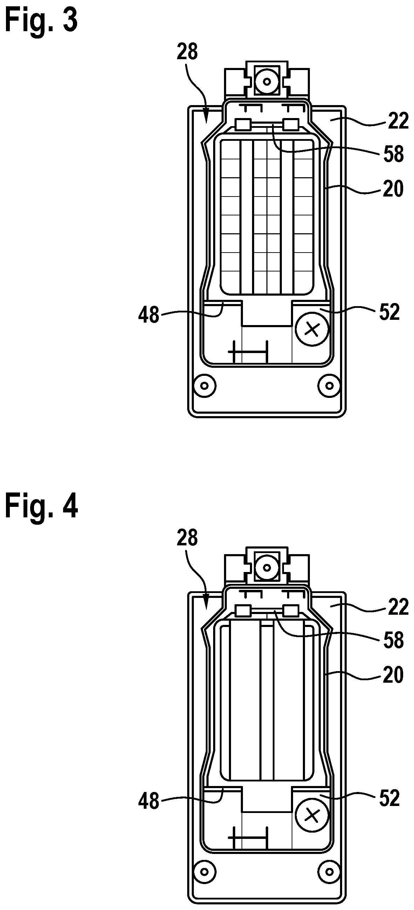

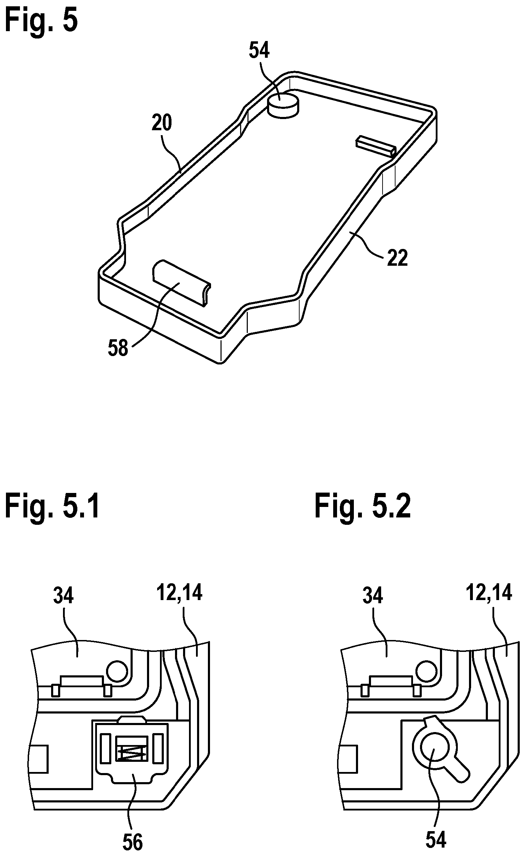

Figur 3 zeigt in Draufsicht den Batteriefachdeckel 22, an dessen Innenseite 28 eine Ausrichtrippe 48 ausgebildet ist. Auf der der Ausrichtrippe 48 gegenüberliegenden Seite kann eine Freigabeeinrichtung 52, wie sie in den Figuren 5, 5.1 und 5.2 im Detail dargestellt ist, angeordnet sein. Des Weiteren umfassen die Montagestrukturen 26 an der Innenseite 28 des Batteriefachdeckels 22 neben der Ausrichtrippe 48 einen L-Haken 50 sowie besagte Freigabeeinrichtung 52, die der Ausrichtrippe 48 gegenüberliegend positioniert werden kann.

Figur 4 zeigt den an der Innenseite 28 des Batteriefachdeckels 22 aufgenommenen wiederaufladbaren Akkumulator 34.

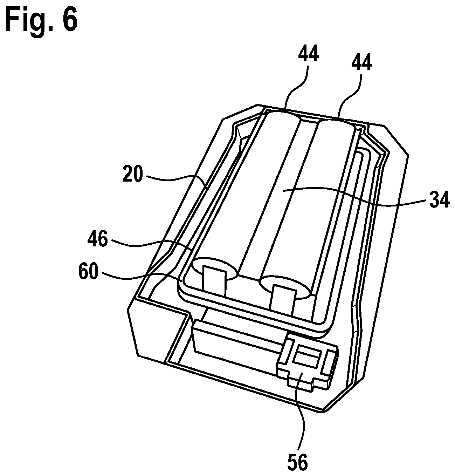

Figur 5 ist zu entnehmen, dass die Fassung 20 des Batteriefachdeckels 22 einen hakenförmigen Vorsprung 58, besagte Ausrichtrippe 48 sowie eine Freigabeeinrichtung 52, hier in Gestalt eines Drehvorsprungs 54 umschließt. Bei dem hakenförmigen Vorsprung 58 handelt es sich beispielsweise um einen mittels des Spritzgießverfahrens bei der Fertigung des Batteriefachdeckels 22 herstellbaren Vorsprung, der eine Umrandung 60 des Gehäuses 46 des wiederaufladbaren Akkumulators 34 oder Akkupacks umschließt, wie beispielsweise in Figur 6 dargestellt ist. Auf der gegenüberliegenden Seite des hakenförmigen Vorsprungs 58 befinden sich am Batteriefachdeckel 22 besagte Ausrichtrippe 48 und der federbeaufschlagte Drehvorsprung 54.

Anstelle des in Figur 5.2 dargestellten federbeaufschlagten Drehvorsprungs 54 an einer Ecke des Batteriefachdeckels 22 kann alternativ auch der in Figur 5.1 dargestellte Kippschalter 56 eingesetzt werden. Der Kippschalter 56 ist ebenfalls mittels einer Feder beaufschlagt. Die Federbeaufschlagung der Freigabeeinrichtung 52 in Gestalt des Drehvorsprungs 54 oder des Kippschalters 56 bewirkt, dass beide Freigabeeinrichtungen 52 in Schließrichtung beaufschlagt sind, d. h. nach der Ausrichtung an der Innenseite 28 des Batteriefachdeckels 22 den wiederaufladbaren Akkumulator 34 oder den Akkupack in seiner Einbauposition lösbar fixieren.

Der Darstellung gemäß Figur 6 ist zu entnehmen, dass der wiederaufladbare Akkumulator 34 oder der Akkupack mit seinem Gehäuse 46 an der Innenseite 28 des Batteriefachdeckels 22 fixiert ist. In Figur 6 ist die Freigabeeinrichtung 52 als Kippschalter 56 ausgebildet. In seiner Schließstellung übergreift der federbeaufschlagte Kippschalter 56 eine Umrandung 60 des Gehäuses 46 des wiederaufladbaren Akkumulators 34 oder Akkupacks. Dieser ist am Batteriefachdeckel 22, umgeben von der hier kontinuierlich ausgebildeten Fassung 20, temporär fixiert. Bei Betätigung des Kippschalters 56 lässt sich der wiederaufladbare Akkumulator 34 oder Akkupack mit einem Handgriff aus dem Batteriefachdeckel 22 entnehmen, solange der Kippschalter 56 manuell gedrückt bleibt. Somit ist ein sehr einfacher Austausch des wiederaufladbaren Akkumulators 34 oder Akkupacks am Batteriefachdeckel 22 möglich.

Durch die erfindungsgemäß vorgeschlagene Lösung kann das elektronische Messgerät 10, ob ein Multimeter, ein Zangenamperemeter, ein Gabelamperemeter oder ein Spannungsmesser, im Dual Use betrieben werden. Dies bedeutet, dass sich das elektronische Messgerät 10 sowohl mit in das Batteriefach 16 eingelegten herkömmlichen Batterien 24, d. h. Alkaline-Batterien 18, betreiben lässt als auch mit einem am Batteriefachdeckel 22 aufnehmbaren wiederaufladbaren Akkumulator 34 oder einem Akkupack mit mehreren Akkumulatoren, ohne dass ein Adapter erforderlich ist. Dadurch ist dem Bediener des erfindungsgemäß vorgeschlagenen elektronischen Messgerätes 10 ein sehr einfacher Gebrauch desselben möglich. Des Weiteren ist durch die erfindungsgemäß vorgeschlagene Lösung sichergestellt, dass bei Lösen des Batteriefachdeckels 22 der an diesem fixierte wiederaufladbare Akkumulator 34 oder Akkupack bei Entnahme des Batteriefachdeckels 36 aus dem Gehäuse 12 entfernt wird. Damit wird verhindert, dass der wiederaufladbare Akkumulator 34 oder der Akkupack im Batteriefach 16 verbleibt. Durch die sichere Entnahme des wiederaufladbaren Akkumulators 34 oder des Akkupacks aus dem Batteriefach 16 bei Öffnen des Batteriefachdeckels 22 hat der Bediener des elektronischen Messgerätes 10 keine Möglichkeit, den wiederaufladbaren Akkumulator 34 oder den Akkupack innerhalb des Batteriefachs 16 aufzuladen. Dadurch kann die Bediensicherheit des erfindungsgemäß vorgeschlagenen elektronischen Messgerätes 10 erheblich verbessert werden, da der Bediener davon abgehalten wird, den wiederaufladbaren Akkumulator 34 oder den Akkupack im in das Batteriefach 16 eingelegten Zustand aufzuladen.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Elektronisches Messgerät (10) zur Messung elektrischer Größen, insbesondere von Strömen, Spannungen und/oder von ohmschen Widerständen, in dessen Gehäuse (12) ein Batteriefach (16) zur Aufnahme einer Energiequelle (17) ausgebildet ist, welches mittels eines Batteriefachdeckels (22) verschließbar ist, **dadurch gekennzeichnet, dass** der Batteriefachdeckel (22) eingerichtet ist, sowohl das Batteriefach (16) mit in dieses eingelegten Batterien (24) als auch mit am Batteriefachdeckel (22) bestücktem, wiederaufladbarem Akkumulator (34) oder Akkupack, bestehend aus mehreren wiederaufladbaren Akkumulatoren (34) zu verschließen.

2. Elektronisches Messgerät (10) gemäß Anspruch 1, **dadurch gekennzeichnet, dass** an einer Innenseite (28) des Batteriefachdeckels (22) den wiederaufladbaren Akkumulator (34) oder den Akkupack fixierende Montagestrukturen (26) angeordnet sind.

3. Elektronisches Messgerät (10) gemäß den Ansprüchen 1 bis 2, **dadurch gekennzeichnet, dass** die Montagestrukturen (26) derart ausgeführt sind, dass der wiederaufladbare Akkumulator (34) oder ein wiederaufladbarer Akkupack in Umfangsrichtung von den Montagestrukturen (26) umgriffen ist, in Umfangsrichtung an den Montagestrukturen (26) anliegt oder die Montagestrukturen (26) aufnimmt.

4. Elektronisches Messgerät (10) gemäß den Ansprüchen 1 bis 3, **dadurch gekennzeichnet, dass** der wiederaufladbare Akkumulator (34) oder der Akkupack an der Innenseite (28) des Batteriefachdeckels (22) von einem hakenförmigen Vorsprung (58) übergriffen und fixiert ist.

5. Elektronisches Messgerät (10) gemäß den Ansprüchen 1 bis 4, **dadurch gekennzeichnet, dass** der wiederaufladbare Akkumulator (34) oder der Akkupack an einer dem hakenförmigen Vorsprung (58) an der Innenseite (28) des Batteriefachdeckels (22) gegenüberliegenden Seite mittels einer Ausrichtrippe (48) und einer Freigabeeinrichtung (52) fixiert ist.

6. Elektronisches Messgerät (10) gemäß den Ansprüchen 1 bis 5, **dadurch gekennzeichnet, dass** die Freigabeeinrichtung (52) als Drehvorsprung (54) oder als Kippschalter (56) ausgeführt ist.

7. Elektronisches Messgerät (10) gemäß den Ansprüchen 1 bis 6, **dadurch gekennzeichnet, dass** der Drehvorsprung (54) oder der Kippschalter (56) jeweils mittels eines Federelements beaufschlagt sind, welches den Drehvorsprung (54) beziehungsweise den Kippschalter (56) in Schließrichtung drängt.

8. Elektronisches Messgerät (10) gemäß den Ansprüchen 1 bis 7, **dadurch gekennzeichnet, dass** der Drehvorsprung (54) oder der Kippschalter (56) eine Umrandung [Außenkontur (44)?] des wiederaufladbaren Akkumulators (34) oder des Akkupacks im an den Batteriefachdeckel (22) montierten Zustand übergreifen.

9. Elektronisches Messgerät (10) gemäß den Ansprüchen 1 bis 8, **dadurch gekennzeichnet, dass** eine Bodenkontur (42) des Batteriefachs (16) komplementär zur Außenkontur (44) eines Gehäuses (46) des wiederaufladbaren Akkumulators (34) oder Akkupacks ausgebildet ist.

10. Elektronisches Messgerät (10) gemäß einem der Ansprüche 1 bis 9, **dadurch gekennzeichnet, dass** dieses als Multimeter, als Zangenamperemeter, als Gabelamperemeter oder als Spannungsmesser zur Messung elektrischer Größen ausgeführt ist, insbesondere von Strömen, Spannungen, elektrischen Widerständen, Kapazitäten, Temperaturen oder Impedanzen in Gleichstrom- oder Wechselstromanwendungen.
